# EUROPEAN PATENT APPLICATION

(11) **EP 4 668 050 A1**
(43) Date of publication of application: **24.12.2025**
(21) Application number: 24857733.0
(22) Date of filing: 25.03.2024
(51) Int. Cl.: G06F 1/16

(54) **ROTATING SHAFT AND ELECTRONIC DEVICE**

(30) Priority: 28.08.2023 CN 202311082908
(71) Applicant: Honor Device Co., Ltd., Shenzhen, Guangdong 518040 (CN)
(72) Inventor: JIANG, Tianli, Shenzhen, Guangdong 518040 (CN); DONG, Shaohong, Shenzhen, Guangdong 518040 (CN); CHEN, Ruihao, Shenzhen, Guangdong 518040 (CN)
(74) Representative: Gill Jennings & Every LLP
(86) International application number: PCT/CN2024/083484
(87) International publication number: WO 2025/044181

(57) **Abstract**

This application provides a rotating shaft and an electronic device. The rotating shaft includes at least one damping module, where the damping module includes a mounting shaft, a rotating member, a first cam, and a second cam, the rotating member, the first cam, and the second cam are all rotatably connected to the mounting shaft, a first mating gear tooth is disposed at a first end of the rotating member, and a second mating gear tooth is disposed at a second end of the rotating member. A first gear tooth is disposed on the first cam, the first gear tooth includes a first damping part, and a first included angle exists between the first damping part and a radial direction of the mounting shaft. A second gear tooth is disposed on the second cam, the second gear tooth includes a hovering part, a second included angle exists between the hovering part and the radial direction of the mounting shaft, and the second included angle is greater than the first included angle. A mating gear tooth of the rotating member may mate with the first gear tooth or the second gear tooth. In this application, mating between the first cam and the second cam that have different profiles can simultaneously implement hand feeling feedback during opening and closing and a hovering function of the electronic device, and this is easy to design.

## Description

The present invention claims priority to Chinese Patent Application No. 202311082908.7, filed with the China National Intellectual Property Administration on August 28, 2023 and entitled "ROTATING SHAFT AND ELECTRONIC DEVICE", which is incorporated herein by reference in its entirety.

### TECHNICAL FIELD

This application relates to the field of electronic product technologies, and in particular, to a rotating shaft and an electronic device.

### BACKGROUND

With the development of a foldable electronic device, a user has a relatively high requirement for a folding hand feeling and a hovering angle of the foldable electronic device. A conventional damping mechanism includes only one cam profile. This profile controls hand feelings during opening and closing of the folding device in a folded state and a flattened state, and controls a hovering design, which is difficult to adjust.

### SUMMARY

An objective of this application is to provide a rotating shaft and an electronic device, to adjust hand feelings during opening and closing and a hovering angle by using a combination of different profiles.

A first aspect of this application provides a rotating shaft, including at least one damping module, and the damping module includes:
a mounting shaft;
a rotating member, where the rotating member is rotatably connected to the mounting shaft and is in an axial direction of the mounting shaft, the rotating member is in sliding fit with the mounting shaft, a first mating gear tooth is disposed at a first end of the rotating member, and a second mating gear tooth is disposed at a second end of the rotating member;
a first cam, disposed on the mounting shaft, where a first gear tooth is disposed on the first cam, the first gear tooth includes a first damping part, and a first included angle exists between the first damping part and a radial direction of the mounting shaft; and
a second cam, disposed on the mounting shaft, where a second gear tooth is disposed on the second cam, the second gear tooth includes a hovering part, a second included angle exists between the hovering part and the radial direction of the mounting shaft, and the second included angle is greater than the first included angle; where
the second mating gear tooth of the rotating member is in sliding contact with the second gear tooth of one second cam, and the first mating gear tooth of the rotating member is in sliding fit with the first gear tooth of one first cam, or is in sliding contact with the second gear tooth of another second cam.

Therefore, in this application, mating between the first cam and the second cam that have different profiles can simultaneously implement hand feeling feedback during opening and closing and a hovering function of the electronic device. In addition, cams of the two profiles can be separately designed according to corresponding functions, and design difficulty is low.

In a possible design, the second included angle is 10°~35°. In this angle range, the electronic device can implement hovering in a relatively large opening and closing angle range.

In a possible design, the first included angle is 0~10°. In this angle range, the first damping part is relatively gentle, so that when mating between the first mating gear tooth of the rotating member and the first damping part on the first cam is implemented, there is a nearly constant damping force between the rotating member and the first cam, and the damping force is less than a damping force between the second mating gear tooth and the hovering part of the second cam. Therefore, not only a smooth folding action of the electronic device can be ensured to prevent jamming, but also a hovering effect can be ensured.

In a possible design, a length of the hovering part is greater than a length of the first damping part. A position at which the first damping part is in contact and mates with the first mating gear tooth corresponds to a part of an angle range in which the electronic device hovers. However, because a first angle is relatively small, it is difficult to obtain a good hovering effect by using mating between the first cam and the rotating member. Therefore, the hovering effect can be obtained by using mating between the second cam and the rotating member. In addition, the length of the hovering part is enabled to be greater than the length of the first damping part, and hovering can be implemented in a larger angle range.

In a possible design, the first gear tooth further includes a second damping part and a third damping part, the second damping part and the third damping part are respectively located on two sides of the first damping part, and are smoothly transitioned to the first damping part. Both the second damping part and the third damping part extend in a direction away from the rotating member, and a distance between the second damping part and the third damping part gradually increases from a side closer to the first damping part to a side away from the first damping part.

When a mating gear tooth on the rotating member passes through the second damping part and the first damping part, or passes through the first damping part and the third damping part, a sudden force change may be generated between the rotating member and the first cam, so that hand feelings fed back during opening and closing can be obtained.

In a possible design, the rotating shaft further includes a slider and an elastic member, the slider is connected to the mounting shaft, one end of the elastic member is connected to the first cam, and the other end of the elastic member is connected to the slider. The first cam is slidably connected to the mounting shaft. The second cam, the slider, and the mounting shaft may move synchronously to adjust a position of the second cam relative to the rotating member, to ensure that the second cam can keep in contact with the rotating member. In addition, the elastic member may push, through elastic deformation of the elastic member, the first cam to slide relative to the mounting shaft to ensure that the first cam can keep in contact with the rotating member, so that hand feelings during opening and closing can be obtained by providing a damping force by using the first cam, and a hovering function can be implemented in a large angle range.

In a possible design, the rotating shaft further includes a circlip, the circlip is fixedly sleeved onto the mounting shaft, the slider is disposed between the circlip and the elastic member, and two sides of the slider respectively abut against the circlip and the elastic member. The circlip may be fastened to the mounting shaft, so that limiting in the axial direction on the slider can be implemented. In addition, the elastic member is elastically deformed between the first cam and the slider, so that an axial position of the first cam is adaptively adjusted.

In a possible design, the mounting shaft includes a first shaft and a second shaft, the first shaft and the second shaft are disposed in parallel, the rotating member includes a first swing arm and a second swing arm, the first swing arm is rotatably connected to the first shaft, and the second swing arm is rotatably connected to the second shaft; and a first hole and a second hole are disposed on the first cam, the first cam is slidably sleeved onto the first shaft through the first hole, and the first cam is slidably sleeved onto the second shaft through the second hole, so that the first cam can slide relative to the mounting shaft. The first gear teeth are disposed on the first cam around the first hole and the second hole, a first mating gear tooth at a first end of the first swing arm is in sliding contact with the first gear tooth of the first cam around the first hole, and a first mating gear tooth at a first end of the second swing arm is in sliding contact with the first gear tooth of the first cam around the second hole. The first cam is an integrally formed structure, and can directly form the first hole, the second hole, and the first gear teeth around the first hole and the second hole in a forming process. Therefore, in a rotating process of the first swing arm and the second swing arm, a same force state exists between the first swing arm and the first cam and between the second swing arm and the first cam.

In a possible design, a third hole and a fourth hole are disposed on the second cam, the second cam is sleeved onto the first shaft through the third hole, and the second cam is sleeved onto the second shaft through the fourth hole, where a shaft shoulder or a circlip may be disposed on the first shaft and the second shaft, and the shaft shoulder or the circlip may be disposed on a side of the second cam facing away from the first cam, to implement limiting in the axial direction on the second cam, and the second cam can maintain a contact state with the shaft shoulder or the circlip by using a spring force provided by the elastic member, so that the second cam cannot slide relative to the mounting shaft but can move synchronously with the mounting shaft. The second gear teeth are disposed on the second cam around the third hole and the fourth hole, a second mating gear tooth at a second end of the first swing arm is in sliding contact with the second gear tooth of the second cam around the third hole, and a second mating gear tooth at a second end of the second swing arm is in sliding contact with the second gear tooth of the second cam around the fourth hole. The second cam is an integrally formed structure, and can directly form the third hole, the fourth hole, and the second gear teeth around the third hole and the fourth hole in a forming process. Therefore, in a rotating process of the first swing arm and the second swing arm, a same force state exists between the first swing arm and the second cam and between the second swing arm and the second cam.

In a possible design, a fifth hole and a sixth hole are disposed on the slider, the slider is sleeved onto the first shaft through the fifth hole, and the slider is sleeved onto the second shaft through the sixth hole. The slider may also be an integrally formed structure, so that a consistent state of connecting to the mounting shaft at the fifth hole and the sixth hole can be ensured, thereby improving consistency.

In a possible design, a plurality of damping modules are disposed, and some of the damping modules include the first cam and the second cam, and/or some of the damping modules include two first cams, and/or some of the damping modules include two the second cams. Therefore, the design and application of the structure of the damping module can be more flexible.

A second aspect of this application further provides an electronic device, where the electronic device includes a first body, a second body, and the rotating shaft provided in the first aspect of this application, and the first body and the second body are rotatably disposed on two sides of the rotating shaft respectively by using a rotating member in the rotating shaft.

The electronic device including the rotating shaft has a technical effect similar to that of the rotating shaft, and details are not described herein again.

It should be understood that the foregoing general descriptions and the following detailed descriptions are only examples, and cannot limit this application.

### BRIEF DESCRIPTION OF DRAWINGS

FIG. 1 is a schematic diagram of an electronic device in a flattened state according to an embodiment of this application;
FIG. 2 is a schematic diagram of an electronic device in a folded state according to an embodiment of this application;
FIG. 3 is a schematic structural diagram of a rotating shaft according to an embodiment of this application;
FIG. 4 is a front view of FIG. 3;
FIG. 5 is a schematic structural diagram of a damping module in one angle of view according to an embodiment of this application;
FIG. 6 is a schematic structural diagram of a damping module in another angle of view according to an embodiment of this application.
FIG. 7 is a front view of a damping module according to an embodiment of this application;
FIG. 8 is another schematic structural diagram of a rotating shaft according to an embodiment of this application;
FIG. 9 is a front view of FIG. 8;
FIG. 10 is a schematic diagram of a profile of a first cam according to an embodiment of this application;
FIG. 11 is a schematic diagram of a profile of a second cam according to an embodiment of this application;
FIG. 12 is a schematic diagram of a profile of a first cam according to an embodiment of this application;
FIG. 13 is a diagram of a torsion curve of a rotating shaft in which only a first cam is included according to an embodiment of this application; and
FIG. 14 is a schematic diagram of comparison between a torsion curve of a rotating shaft that includes both a first cam and a second cam and a torsion curve of a rotating shaft that includes only the first cam according to an embodiment of this application.

### Reference numerals:

100-rotating shaft;
   110-damping module;
   120-structural member;
200-first body;
300-second body;
1-mounting shaft;
   11-first shaft;
   12-second shaft;
2-first cam;
   21-first gear tooth;
   211-first damping part;
   212-second damping part;
   213-third damping part;
   214-first rounded part;
   215-second rounded part;
3-second cam;
   31-second gear tooth;
   311-hovering part;
4-rotating member;
   41-first swing arm;
   42-second swing arm;
   43-first mating gear tooth;
   44-second mating gear tooth;
5-slider
6-elastic member;
7-circlip;
α-first included angle;
β-second included angle;
X-axial direction;
Y-radial direction.

The accompanying drawings which are incorporated into this specification and constitute a part of this specification illustrate the embodiments consistent with this application and serve to explain the principles of this application together with this specification.

### DESCRIPTION OF EMBODIMENTS

To make the objectives, technical solutions, and advantages of this application clearer, the following further describes this application in detail with reference to the accompanying drawings and embodiments. It should be understood that specific embodiments described herein are merely used to explain this application, but are not intended to limit this application.

In the descriptions of this application, unless otherwise specified and defined explicitly, the terms "first" and "second" are merely intended for the purpose of description, and shall not be understood as an indication or implication of relative importance; unless otherwise specified or stated, the term "a plurality of' means two or more; and the terms such as "connection" and "fastening" should be understood in a broad sense. For example, the "connection" may be a fixed connection, a detachable connection, an integrated connection, or an electrical connection; or may be a direct connection or an indirect connection through an intermediate medium. A person of ordinary skill in the art may understand specific meanings of the foregoing terms in this application based on specific cases.

In the descriptions of the specification, it should be understood that the directional words such as "up" and "down" described in the embodiments of this application are described from perspectives shown in the accompanying drawings, and shall not be understood as a limitation on the embodiments of this application. In addition, in the context, it should be further understood that when it is mentioned that an element is connected to another element, the element can be directly connected to the another element, or may be indirectly connected to the another element through an intermediate element.

A foldable electronic device generally includes a screen and a rotating shaft, and a part of the screen on both sides of the rotating shaft may rotate relative to the rotating shaft, to implement screen folding or flattening. Generally, there is a damping module in the rotating shaft, and the damping module may provide a damping force in a folding process of the foldable electronic device, to feed back a hand feeling during folding and hovering at a folding angle to the user. Generally, a plurality of cams are disposed in the damping module, and profiles of the cams are consistent. The damping force is provided by using this profile to meet hand feelings during opening and closing of the foldable electronic device and a required hovering angle. However, a single profile usually meets only a design requirement of a damping force or a hovering angle, and it is difficult for a single profile to meet design requirements of both.

An embodiment of this application provides a rotating shaft. The rotating shaft 100 may be applied to an electronic device. The electronic device may be a device that has the rotating shaft 100 and that can be folded relative to the rotating shaft 100, such as a foldable mobile phone or a foldable tablet computer. This embodiment sets no limitation on a type of the electronic device.

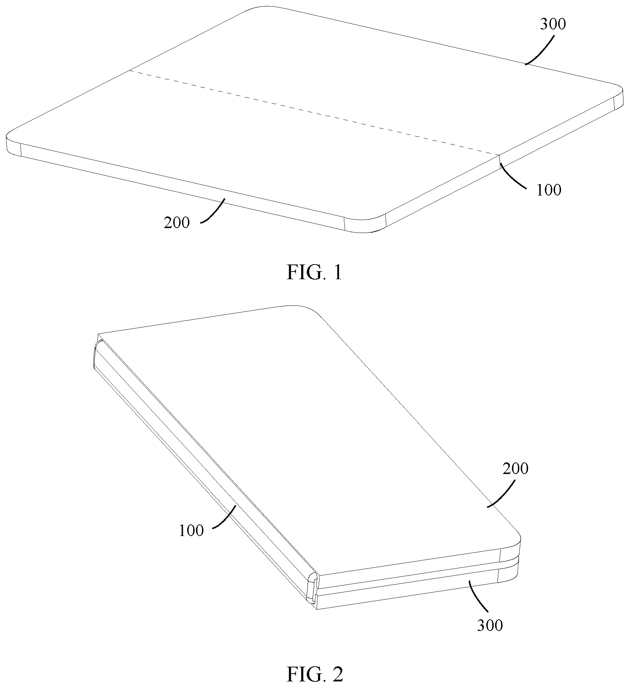

FIG. 1 is a schematic diagram of the electronic device in a flattened state according to an embodiment of this application. FIG. 2 is a schematic diagram of the electronic device in a folded state according to an embodiment of this application. FIG. 1 and FIG. 2 show only examples in which the electronic device is a foldable mobile phone, and are used as examples for description. Referring to FIG. 1 and FIG. 2, the electronic device includes a first body 200 and a second body 300, and the first body 200 and the second body 300 are rotatably disposed on both sides of the rotating shaft 100 by using a rotating member 4 in the rotating shaft 100. When the electronic device is a foldable mobile phone, the first body 200 and the second body 300 each may be a middle frame of the foldable mobile phone, the middle frame may be covered with a flexible screen, and the flexible screen can be bent at a position corresponding to the rotating shaft 100.

In this embodiment, the rotating shaft 100 includes at least one damping module 110. There may be one or at least two damping modules 110, and may provide a damping force of the electronic device in a rotating process, to feed back hand feelings during opening and closing of the electronic device, and may further implement hovering of the electronic device when opened or closed to a proper angle.

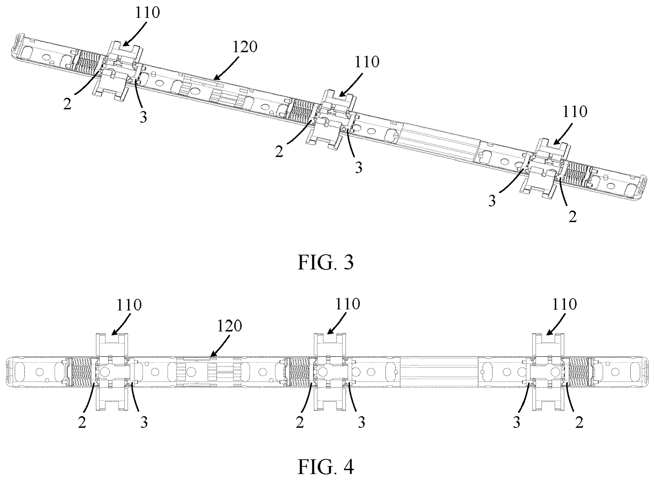

FIG. 3 is a schematic structural diagram of the rotating shaft 100 according to an embodiment of this application. FIG. 4 is a front view of FIG. 3. Referring to FIG. 3 and FIG. 4, the rotating shaft 100 further includes a structural member 120. The structural member 120 may be a housing of the rotating shaft 100. The damping module 110 is disposed on the structural member 120. The structural member 120 may provide a mounting environment for the damping module 110, and may further provide a protection effect for the damping module 110.

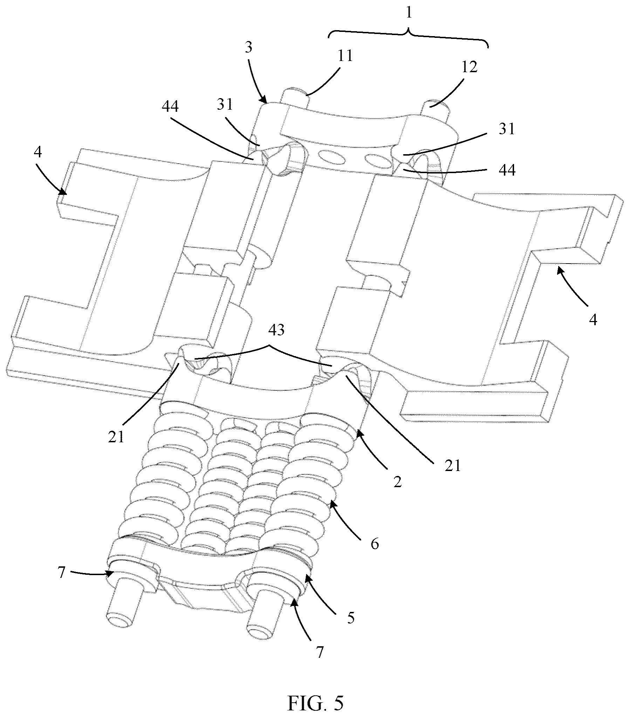

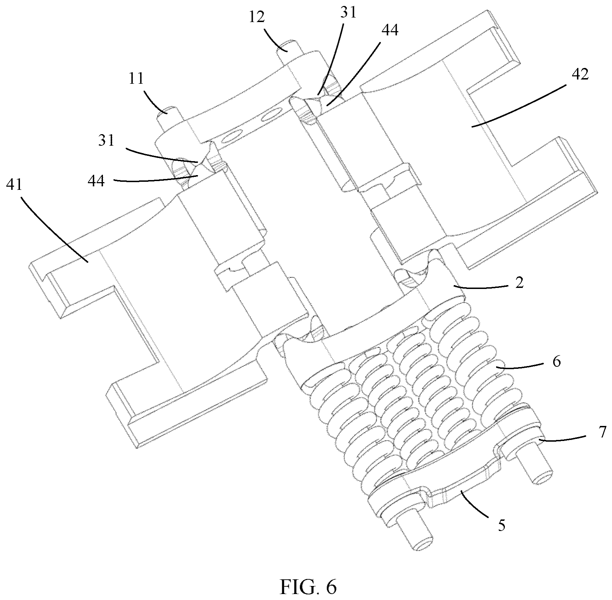

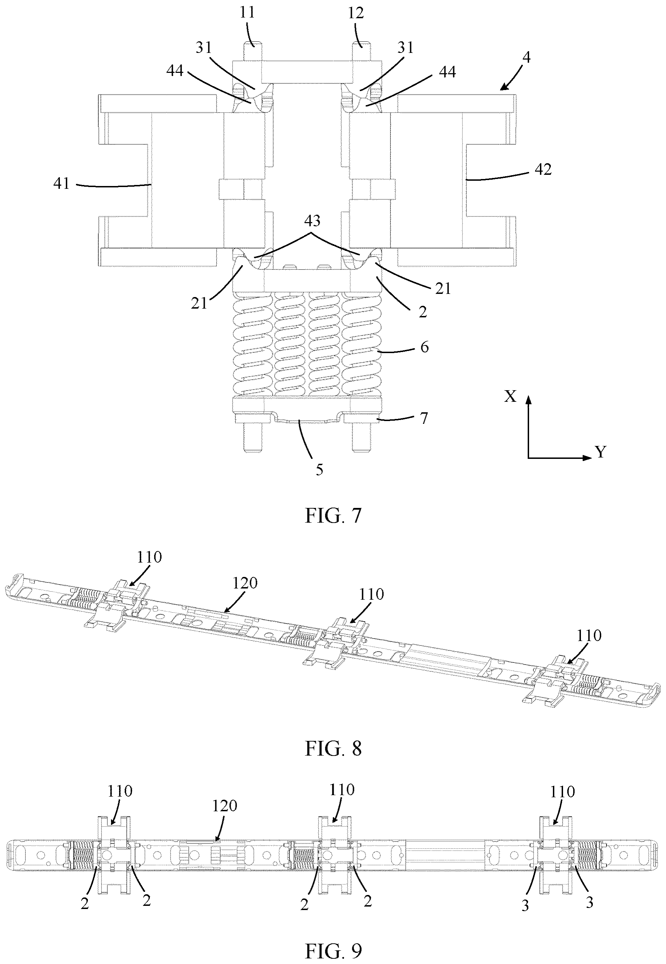

FIG. 5 is a schematic structural diagram of the damping module 110 in one angle of view according to an embodiment of this application. FIG. 6 is a schematic structural diagram of the damping module 110 in another angle of view according to an embodiment of this application. FIG. 7 is a front view of the damping module 110 according to an embodiment of this application. Referring to FIG. 5 to FIG. 7, the damping module 110 includes a rotating member 4, where the rotating member 4 may be connected to the first body 200 or the second body 300 of the electronic device. For example, in one damping module 110, at least two rotating members 4 may be disposed, where at least one rotating member 4 may be connected to the first body 200 of the electronic device, and at least one another rotating member 4 may be connected to the second body 300 of the electronic device. Therefore, a connection between the first body 200, the second body 300, and the rotating shaft 100 may be implemented by using the rotating member 4, and flattening or folding of the electronic device may be implemented by using the rotating member 4 driving relative rotation between the first body 200 and the second body 300.

Referring to FIG. 7, the damping module 110 further includes a mounting shaft 1. The rotating member 4 is rotatably sleeved onto the mounting shaft 1. The rotating member 4 has only rotational motion in the rotating shaft 100 without displacement, and the mounting shaft 1 may move relative to the rotating member 4 in an axial direction X. Both a first cam 2 and a second cam 3 are connected to the mounting shaft 1, the second cam may be relatively fixed to the mounting shaft 1 and can move synchronously in the axial direction X with the mounting shaft 1, and relative sliding may occur between the first cam and the mounting shaft 1. A surface that is on a gear tooth of each of the first cam 2 and the second cam 3 and that is used to mate with the rotating member 4 is a curved surface. When the rotating member 4 is in contact with different positions on the gear teeth of the first cam 2 and the second cam 3, a distance between each of the first cam 2 and the second cam 3 and the rotating member 4 in the axial direction X is changed. In this case, when the rotating member 4 is in contact and mates with different positions of the first cam 2, the first cam 2 can slide relative to the mounting shaft 1, the first cam 2, the mounting shaft 1, the rotating member 4, and the axial direction X at the same time. When the rotating member 4 is in contact and mates with different positions of the second cam 3, the second cam 3 and the mounting shaft 1 may move synchronously relative to the rotating member 4 in the axial direction X. In this way, the second cam 3 may ensure that the rotating member 4 rotates relative to the mounting shaft 1 without jamming and can ensure that damping force feedback during opening and closing of the entire device is implemented through contact with the first cam 2, and a hovering function is implemented through contact with the second cam 3.

Referring to FIG. 7, a first gear tooth 21 is disposed on the first cam 2, and a second gear tooth 31 is disposed on the second cam 3. Along the axial direction X of the mounting shaft 1, a first mating gear tooth 43 is disposed at a first end of the rotating member 4, a second mating gear tooth 44 is disposed at a second end of the rotating member 4, and both the first mating gear tooth 43 and the second mating gear tooth 44 can mate with one of the first gear tooth 21 and the second gear tooth 31. The first gear tooth 21 and the second gear tooth 31 have different profiles. For example, in a same damping module 110, the first mating gear tooth 43 may mate with the first gear tooth 21 of one first cam 2, and the second mating gear tooth 44 may mate with the first gear tooth 21 of another first cam 2. In this case, the first mating gear tooth 43 and the second mating gear tooth 44 may have a same profile. Certainly, the first mating gear tooth 43 and the second mating gear tooth 44 may also have a same profile as the first gear tooth 21. For example, in a same damping module 110, the first mating gear tooth 43 may mate with the second gear tooth 31 of one second cam 3, and the second mating gear tooth 44 may mate with the second gear tooth 31 of another second cam 3. In this case, the first mating gear tooth 43 and the second mating gear tooth 44 may have a same profile. Certainly, the first mating gear tooth 43 and the second mating gear tooth 44 may also have a same profile as the second gear tooth 31. For example, in a same damping module 110, the first mating gear tooth 43 may mate with the first gear tooth 21 of one first cam 2, and the second mating gear tooth 44 may mate with the second gear tooth 31 of one second cam 3. In this case, the first mating gear tooth 43 may have a same profile as the first gear tooth 21, and the second mating gear tooth 44 may have a same profile as the second gear tooth 31.

The first cam 2 can provide a damping force for the electronic device through mating between the first gear tooth 21 and the first mating gear tooth 43 on the rotating member 4, to feed back hand feelings during opening and closing to the user. Through mating between the second gear tooth 31 and the second mating gear tooth 44 on the rotating member 4, the second cam 3 can enable the electronic device to implement folding hovering within a specific angle range. For example, referring to FIG. 3 and FIG. 4, when one damping module 110 includes both the first cam 2 and the second cam 3, hand feelings during opening and closing of the entire device and a hovering function can be met by using one damping module 110. Certainly, a plurality of damping modules 110 may be applied to the rotating shaft 100 to improve overall hand feelings during opening and closing and a hovering effect. For example, FIG. 8 is another schematic structural diagram of the rotating shaft 100 according to an embodiment of this application. FIG. 9 is a front view of FIG. 8. Referring to FIG. 8 and FIG. 9, when a damping module 110 includes only the first cam 2 or the second cam 3, at least one damping module 110 including only the first cam 2 and at least one damping module 110 including only the second cam 3 may be used in combination in the rotating shaft 100. The damping module 110 including only the first cam 2 meets a requirement of the hand feelings during opening and closing of the entire device, and the damping module 110 including only the second cam 3 meets the hovering function of the entire device. Therefore, the hand feelings during opening and closing of the entire device and the hovering function may also be implemented at the same time.

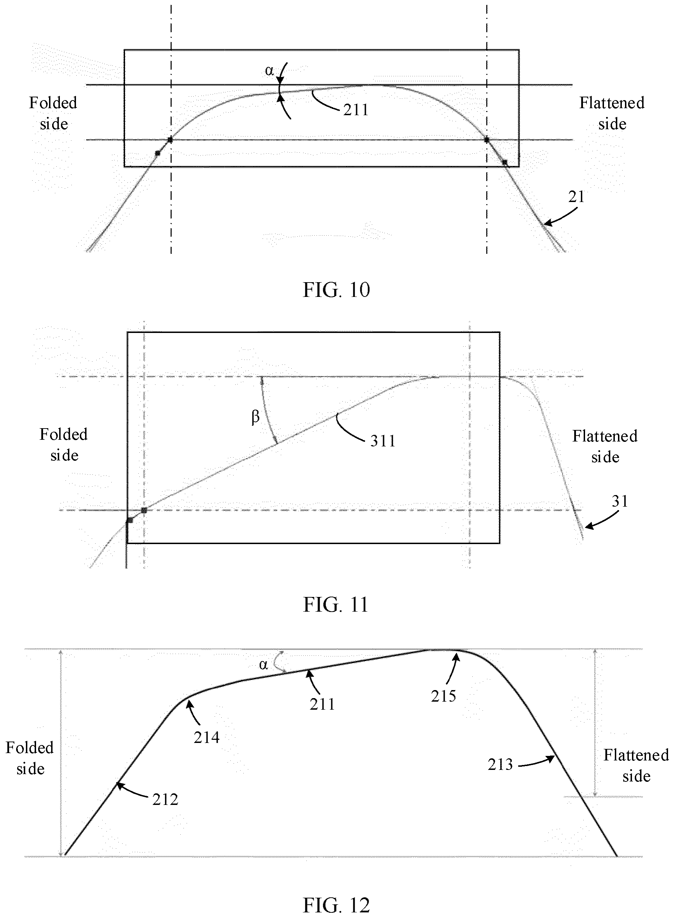

FIG. 10 is a schematic diagram of a profile of the first cam 2 according to an embodiment of this application. Referring to FIG. 10, the first gear tooth 21 includes a first damping part 211, and a first included angle α exists between the first damping part 211 and a radial direction Y of the mounting shaft 1. FIG. 11 is a schematic diagram of a profile of the second cam 3 according to an embodiment of this application. Referring to FIG. 11, the second gear tooth 31 includes a hovering part 311, a second included angle β exists between the hovering part 311 and the radial direction Y of the mounting shaft 1, and the second included angle β is greater than the first included angle α.

For ease of description, that the damping module 110 includes both the first cam 2 and the second cam 3 is used as an example for description. In a process in which the electronic device switches from a folded state to a flattened state, for a process in which the rotating member 4 mates with the first cam 2, the first mating gear tooth 43 can respectively obtain different force feedback before and after contact with the first damping part 211, to implement different hand feelings during opening and closing. For example, FIG. 12 is a schematic diagram of a profile of the first cam 2 according to an embodiment of this application. Referring to FIG. 12, the first gear tooth 21 further includes a second damping part 212 and a third damping part 213, and the second damping part 212 and the third damping part 213 are respectively located on two sides of the first damping part 211, and are smoothly transitioned to the first damping part 211. Both the second damping part 212 and the third damping part 213 extend in a direction away from the rotating member 4, and a distance between the second damping part 212 and the third damping part 213 gradually increases from a side closer to the first damping part 211 to a side away from the first damping part 211. There is no definite boundary between the first damping part 211, the second damping part 212, and the third damping part 213, and the first damping part 211, the second damping part 212, and the third damping part 213 may form a complete continuous gear tooth surface. For ease of description in this embodiment, the gear tooth surface is divided into the foregoing three damping parts, and each damping part has at least a part of position that can contact a mating gear tooth on the rotating member 4, to provide a corresponding damping force for the rotating member 4.

Referring to FIG. 12, a first rounded part 214 exists between the first damping part 211 and the second damping part 212. The first rounded part 214 may cause an included angle between the first damping part 211 and the second damping part 212 in an extension direction. Similarly, a second rounded part 215 exists between the first damping part 211 and the third damping part 213. The second rounded part 215 may cause an included angle between the first damping part 211 and the third damping part 213 in an extension direction, that is, a slope of each of the second damping part 212 and the third damping part 213 is relatively steep, and a slope of the first damping part 211 is relatively gentle.

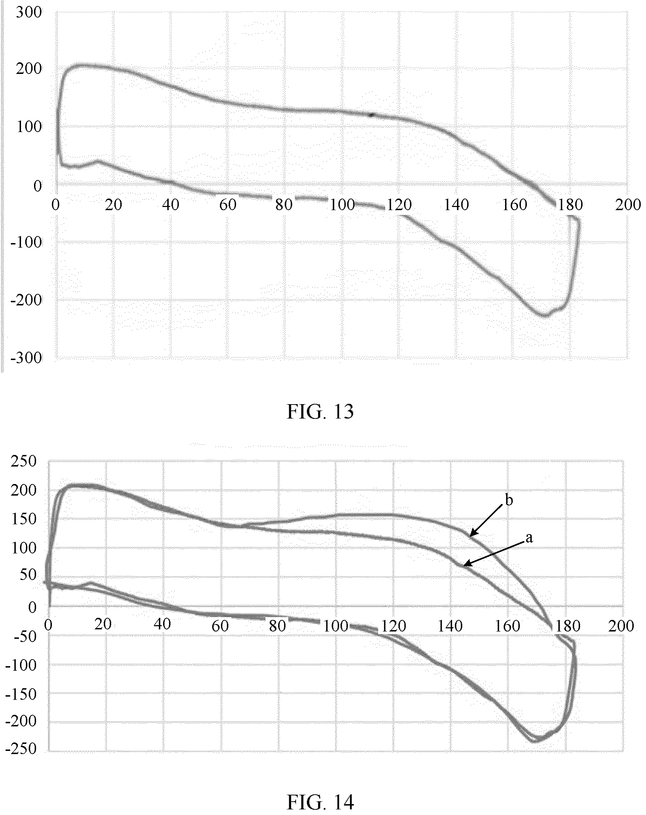

FIG. 13 is a diagram of a torsion curve of the rotating shaft 100 in a case where only the first cam 2 is included according to an embodiment of this application. Referring to FIG. 12 and FIG. 13, when the electronic device rotates from the folded state to the flattened state, the first mating gear tooth 43 on the rotating member 4 first contacts the second damping part 212. Because a slope of the second damping part 212 is relatively large, a damping force between the second damping part 212 and the first mating gear tooth 43 of the rotating member 4 is relatively large, and a torsion force of the rotating shaft 100 is relatively large. When the electronic device is opened by an angle, the first mating gear tooth 43 contacts the first damping part 211 after crossing the first rounded part 214. Because a slope of the first damping part 211 is relatively small, the damping force between the first cam 2 and the rotating member 4 changes greatly after the first mating gear tooth 43 passes through the first rounded part 214. That is, the damping force decreases, and the torsion force of the rotating shaft 100 decreases. A sudden torsion force change of the rotating shaft 100 may feed back hand feelings during opening and closing for the first time to the user, and the hand feeling represents a hand feeling when the electronic device starts to expand the electronic device.

As the electronic device continues to expand towards the flattened state, the first mating gear tooth 43 is in sliding contact with the first damping part 211. Because the slope of the first damping part 211 is relatively gentle, the damping force between the rotating member 4 and the first cam 2 is relatively stable.

When the first mating gear tooth 43 is in contact with the third damping part 213 after crossing the second rounded part 215, because a slope of the third damping part 213 is relatively large, a damping force between the first cam 2 and the rotating member 4 changes greatly after the first mating gear tooth 43 passes through the second rounded part 215, so that hand feelings during opening and closing for the second time can be fed back for the user, and the hand feeling represents a hand feeling when the electronic device is about to complete flattening.

In addition, when the electronic device switches from the flattened state to the folded state, a movement path of the first mating gear tooth 43 on the first cam 2 is reversed. A state of a force between the first mating gear tooth 43 and the first gear tooth 21 at a corresponding mating position is similar to a state of a force when the electronic device switches from the folded state to the expanded state described above, and details are not described herein again.

FIG. 14 is a schematic diagram of comparison between a torsion curve of the rotating shaft 100 that includes both the first cam 2 and the second cam 3 and a torsion curve of the rotating shaft 100 that includes only the first cam 2. Horizontal coordinates indicate an angle, vertical coordinates indicate a torsion, a curve a is a torsion curve of the rotating shaft 100 that includes only the first cam 2, and a curve b is a torsion curve of the rotating shaft 100 that includes both the first cam 2 and the second cam 3. Referring to FIG. 14, for a process in which the rotating member 4 mates with the second cam 3, in a process in which the electronic device moves from the folded state to the flattened state, the second mating gear tooth 44 of the rotating member 4 keeps mating with the second gear tooth 31 of the second cam 3. Because the second included angle β is greater than the first included angle α, in an entire process of the first mating gear tooth 43 mating with the first damping part 211, a greater friction force can be generated between the second gear tooth 31 and the second mating gear tooth 44, and the rotating shaft 100 generates a relatively large torsion (referring to a part of the curve b in FIG. 14 that is corresponding to horizontal coordinate angles 60°~120°). That is, referring to FIG. 14, in the horizontal coordinate angles 60°~120°, torsions corresponding to the curve b are greater than torsions corresponding to the curve a, so that the electronic device can implement hovering in a relatively large folding angle range.

Therefore, through mating between the first cam 2 and the second cam 3 that have different profiles, hand feeling feedback during opening and closing and a hovering function of the electronic device can be simultaneously implemented. In addition, cams of two profiles can be separately designed according to corresponding functions, and design difficulty is low.

In an embodiment, the second included angle β may be 10°~35°, and the electronic device can implement hovering within this angle range in a relatively large opening and closing angle range. Optionally, the second included angle β may be 10°, 15°, 20°, 25°, 30°, or 35°, which helps the electronic device to implement hovering within an angle range of 60°~120°.

In an embodiment, the first included angle α may be 0~10°. In this angle range, the first damping part 211 is relatively gentle, so that when mating between the first mating gear tooth 43 of the rotating member 4 and the first damping part 211 of the first cam 2 is implemented, there is a nearly constant damping force between the rotating member 4 and the first cam 2, and the damping force is less than the damping force between the second mating gear tooth 44 and the hovering part 311 of the second cam 3, thereby ensuring a smooth folding action of the electronic device, avoiding jamming, and ensuring a hovering effect. Optionally, the first included angle α may be 3°, 5°, 8°, or 10°.

In an embodiment, a length of the hovering part 311 is greater than a length of the first damping part 211, where a position at which a first damping layer is in contact and mates with the first mating gear tooth 43 corresponds to a part of an angle range in which the electronic device needs to hover. However, because a first angle is relatively small, it is difficult to obtain a good hovering effect depending on mating between the first cam 2 and the rotating member 4. Therefore, a hovering effect can be obtained through mating between the second cam 3 and the rotating member 4. In addition, the length of the hovering part 311 is enabled to greater than the length of the first damping part 211, so that hovering can be implemented in a larger angle range, for example, hovering can be implemented within an angle range of 60°~120°.

In an embodiment, a slider 5 and an elastic member 6 are further included. The slider 5 is connected to the mounting shaft 1, one end of the elastic member 6 is connected to the first cam 2, and the other end of the elastic member 6 is connected to the slider 5. The first cam 2 is slidably connected to the mounting shaft 1. For ease of mounting and disposing, the elastic member 6 may be a spring.

A position of the slider 5 on the mounting shaft 1 is relatively fixed, and the slider 5 can move synchronously with the mounting shaft 1. Because a position of the second cam 3 on the mounting shaft 1 is also relatively fixed, the second cam 3, the slider 5, and the mounting shaft 1 may move synchronously. The first cam 2 may slide relative to the mounting shaft 1 under action of an elastic force of the elastic member 6. When the mating gear teeth on the rotating member 4 are in contact and mate with different parts of the corresponding first gear tooth 21 and second gear tooth 31, the second cam 3, the slider 5, and the mounting shaft 1 may adjust a position of the second cam 3 relative to the rotating member 4 by moving synchronously, to ensure that the second cam 3 can keep in contact with the rotating member 4. In addition, the elastic member 6 may push, through elastic deformation, the first cam 2 to slide relative to the mounting shaft 1, to ensure that the first cam 2 can keep in contact with the rotating member 4, so that a damping force can be provided by the first cam 2 to obtain hand feelings during opening and closing, and a hovering function can be implemented in a large angle range.

In an embodiment, referring to FIG. 7, the rotating shaft 100 further includes a circlip 7, the circlip 7 is fixedly sleeved onto the mounting shaft 1, the slider 5 is disposed between the circlip 7 and the elastic member 6, and two sides of the slider 5 respectively abut against the circlip 7 and the elastic member 6. The circlip 7 may be fastened to the mounting shaft 1, to implement limiting in the axial direction X of the slider 5. In addition, the elastic member 6 is facilitated to be elastically deformed between the first cam 2 and the slider 5, thereby facilitating adaptive position adjustment of the first cam 2 in the axial direction X.

In an embodiment, referring to FIG. 7, the mounting shaft 1 includes a first shaft 11 and a second shaft 12, the first shaft 11 and the second shaft 12 are disposed in parallel, the rotating member 4 includes a first swing arm 41 and a second swing arm 42, the first swing arm 41 is rotatably connected to the first shaft 11, and the second swing arm 42 is rotatably connected to the second shaft 12. A position of the first swing arm 41 and a position of the second swing arm 42 in the electronic device are unchanged along the axial direction X of the mounting shaft 1, and the first swing arm 41 and the second swing arm 42 can rotate only by using a corresponding mounting shaft 1 as a center. The first swing arm 41 may be connected to one of the first body 200 and the second body 300 in the electronic device, and the second swing arm 42 is connected to the other, so that opening and closing of the first body 200 and the second body 300 can be implemented by using the first swing arm 41 and the second swing arm 42. A first hole (not shown in the figure) and a second hole (not shown in the figure) are disposed on the first cam 2, the first cam 2 is slidably sleeved onto the first shaft 11 through the first hole, and the first cam 2 is slidably sleeved onto the second shaft 12 through the second hole, so that the first cam 2 can slide relative to the mounting shaft 1. The first gear teeth 21 are disposed on the first cam 2 around the first hole and the second hole, a first mating gear tooth 43 at a first end of the first swing arm 41 is in sliding contact with the first gear tooth 21 of the first cam 2 around the first hole, and a first mating gear tooth 43 at a first end of the second swing arm 42 is in sliding contact with the first gear tooth 21 of the first cam 2 around the second hole. The first cam 2 is an integrally formed structure, and can directly form the first hole, the second hole, and the first gear teeth 21 around the first hole and the second hole in a forming process. Therefore, in a rotating process of the first swing arm 41 and the second swing arm 42, a same force state exists between the first swing arm 41 and the first cam 2 and between the second swing arm 42 and the first cam 2.

In an embodiment, a third hole (not shown in the figure) and a fourth hole (not shown in the figure) are disposed on the second cam 3, the second cam 3 is sleeved onto the first shaft 11 through the third hole, and the second cam 3 is sleeved onto the second shaft 12 through the fourth hole. A shaft shoulder or a circlip may be disposed on the first shaft 11 and the second shaft 12, and the shaft shoulder or the circlip may be located on a side of the second cam 3 facing away from the first cam 2, to implement limiting in the axial direction on the second cam 3, and the second cam 3 can keep contact with the shaft shoulder or the circlip by using the elastic member 6, so that the second cam 3 cannot slide relative to the mounting shaft 1, and can move synchronously with the mounting shaft 1. The second gear teeth 31 are respectively disposed on the second cam 3 around the third hole and the fourth hole. A second mating gear tooth 44 at a second end of the first swing arm 41 is in sliding contact with the second gear tooth 31 of the second cam 3 around the third hole, and a second mating gear tooth 44 at a second end of the second swing arm 42 is in sliding contact with the second gear tooth 31 of the second cam 3 around the fourth hole. The second cam 3 is an integrally formed structure, and can directly form the third hole, the fourth hole, and the second gear teeth 31 around the third hole and the fourth hole in a forming process. Therefore, in a rotating process of the first swing arm 41 and the second swing arm 42, a same force state exists between the first swing arm 41 and the second cam 3 and between the second swing arm 42 and the second cam 3.

In an embodiment, a fifth hole (not shown in the figure) and a sixth hole (not shown in the figure) are disposed on the slider 5, the slider 5 is sleeved onto the first shaft 11 through the fifth hole, and the slider 5 is sleeved onto the second shaft 12 through the sixth hole. Specifically, an interference fit manner may be used, or the circlip 7 may be used for assisting in fastening. The slider 5 may also be an integrally formed structure, so that a consistent state of connecting to the mounting shaft 1 at the fifth hole and the sixth hole can be ensured, thereby improving consistency.

The foregoing descriptions are merely preferred embodiments of this application, and are not intended to limit this application. A person skilled in the art may make various modifications and changes to this application. Any modification, equivalent replacement, improvement, and the like made within the spirit and principle of this application shall fall within the protection scope of this application.

## Claims

1. A rotating shaft, comprising at least one damping module, the damping module comprising:
a mounting shaft;
a rotating member, wherein the rotating member is rotatably connected to the mounting shaft and is in an axial direction of the mounting shaft, the rotating member is in sliding fit with the mounting shaft, a first mating gear tooth is disposed at a first end of the rotating member, and a second mating gear tooth is disposed at a second end of the rotating member;
a first cam, disposed on the mounting shaft, wherein a first gear tooth is disposed on the first cam, the first gear tooth comprises a first damping part, and a first included angle exists between the first damping part and a radial direction of the mounting shaft; and
a second cam, disposed on the mounting shaft, wherein a second gear tooth is disposed on the second cam, the second gear tooth comprises a hovering part, a second included angle exists between the hovering part and the radial direction of the mounting shaft, and the second included angle is greater than the first included angle; wherein
the second mating gear tooth of the rotating member is in sliding contact with the second gear tooth of one second cam, and the first mating gear tooth of the rotating member is in sliding fit with the first gear tooth of one first cam, or is in sliding contact with the second gear tooth of another second cam.

2. The rotating shaft according to claim 1, wherein the second included angle is 10°~35°.

3. The rotating shaft according to claim 1 or 2, wherein the first included angle is 0°~10°.

4. The rotating shaft according to claim 1 or 2, wherein a length of the hovering part is greater than a length of the first damping part.

5. The rotating shaft according to claim 1 or 2, wherein the first gear tooth further comprises a second damping part and a third damping part, and the second damping part and the third damping part are respectively located on both sides of the first damping part and are smoothly transitioned to the first damping part; and
both the second damping part and the third damping part extend in a direction away from the rotating member, and a distance between the second damping part and the third damping part gradually increases from a side closer to the first damping part to a side away from the first damping part.

6. The rotating shaft according to claim 1 or 2, further comprising a slider and an elastic member, wherein the slider is connected to the mounting shaft, one end of the elastic member is connected to the first cam, and the other end of the elastic member is connected to the slider; and
the first cam is slidably connected to the mounting shaft.

7. The rotating shaft according to claim 6, further comprising a circlip, wherein the circlip is fixedly sleeved onto the mounting shaft, the slider is disposed between the circlip and the elastic member, and both sides of the slider respectively abut against the circlip and the elastic member.

8. The rotating shaft according to claim 6, wherein the mounting shaft comprises a first shaft and a second shaft, the first shaft is disposed parallel to the second shaft, the rotating member comprises a first swing arm and a second swing arm, the first swing arm is rotatably connected to the first shaft, and the second swing arm is rotatably connected to the second shaft; and
a first hole and a second hole are disposed on the first cam, the first cam is slidably sleeved onto the first shaft through the first hole, and the first cam is slidably sleeved onto the second shaft through the second hole; and the first gear teeth are disposed on the first cam around the first hole and the second hole, a first mating gear tooth at a first end of the first swing arm is in sliding contact with the first gear tooth of the first cam around the first hole, and a first mating gear tooth at a first end of the second swing arm is in sliding contact with the first gear tooth of the first cam around the second hole.

9. The rotating shaft according to claim 8, wherein a third hole and a fourth hole are disposed on the second cam, the second cam is sleeved onto the first shaft through the third hole, and the second cam is sleeved onto the second shaft through the fourth hole; and the second gear teeth are disposed on the second cam around the third hole and the fourth hole, a second mating gear tooth at a second end of the first swing arm is in sliding contact with the second gear tooth of the second cam around the third hole, and a second mating gear tooth at a second end of the second swing arm is in sliding contact with the second gear tooth of the second cam around the fourth hole.

10. The rotating shaft according to claim 9, wherein a fifth hole and a sixth hole are disposed on the slider, the slider is sleeved onto the first shaft through the fifth hole, and the slider is sleeved onto the second shaft through the sixth hole.

11. The rotating shaft according to claim 1, wherein a plurality of damping modules are disposed, and some of the damping modules comprise the first cam and the second cam; and/or
some of the damping modules comprise two first cams; and/or
some of the damping modules comprise two second cams.

12. An electronic device, comprising a first body, a second body, and the rotating shaft according to any one of claims 1-11, wherein the first body and the second body are rotatably disposed on two sides of the rotating shaft respectively by using a rotating member in the rotating shaft.
